Europäisches Patentamt

**European Patent Office**

Office européen des brevets

(11) Publication number: **0 054 098**
**A1**

(12) **EUROPEAN PATENT APPLICATION**

(21) Application number: **81104395.9**

(22) Date of filing: **06.06.81**

(51) Int. Cl.³: **H 05 K 9/00**

(30) Priority: **12.12.80 US 215764**

(43) Date of publication of application:
**23.06.82 Bulletin 82/25**

(84) Designated Contracting States:
**AT BE CH DE FR GB IT LI LU NL SE**

(71) Applicant: **W.R. GRACE & CO.**
**62 Whittemore Avenue**
**Cambridge Massachusetts 02140(US)**

(72) Inventor: **Emerson, Cherry L.**
**King Street**
**Sea Island Georgia 31561(US)**

(74) Representative: **UEXKÜLL & STOLBERG Patentanwälte**
**Beselerstrasse 4**
**D-2000 Hamburg 52(DE)**

(54) Metal backed floor which simulates the properties of an infinitely thick earth.

(57) A metal backed floor which has electromagnetic properties similar to those of an infinitely thick earth. The floor comprises at least two layers: a lowermost layer (10) consisting of a metallic material and a second layer (11) disposed upon the lowermost layer and being made of lossy light weight foam material. A third layer (28) made of a rigid nonmetallic material, may be disposed upon the top surface of the second layer (11) for the purpose of supporting equipment to be tested on the floor. The third layer (28) is supported, in turn, by a structural system (29) made of rigid nonmetallic material. The electromagnetic and reflective properties of the floor composition are similar to those properties of the earth, itself.

FIG. 5

Croydon Printing Company Ltd.

## BACKGROUND OF THE INVENTION

This invention relates to a composite base or floor having a finite thickness or depth, and in particular to a floor which has electromagnetic and reflective properties which simulate those of an infinitely thick earth.

Spreading interest in testing electrical and electronic devices for automobiles and other motor vehicles and other devices which operate on the surface of the earth, e.g., aircraft, radios, and television, has brought about a need for a testing environment which must satisfy at least two basic criteria:

(1)   The environment must be free from electromagnetic interference;

(2)   The environment must simulate the earth itself, with respect to electromagnetic and microwave reflective properties.

The first criterion can be satisfied in one of two ways:

(a)   The testing area can be located in a remote location, far from electromagnetic interference; or

(b)   The testing area can be set up in an anechoic chamber.   An anechoic chamber is generally preferred because the testing environment within the chamber is independent of the weather conditions outside the chamber.

None of the patents in the prior art discloses a means or apparatus which would enable the floor of an anechoic chamber to simulate the earth with respect to reflectivity of microwave energy.

The chief difficulty in constructing a floor or surface that will simulate a true earth floor is the space constraint. It is estimated that a hole of approximately 100 feet in depth would have to be sunk in the earth in order to provide the means to establish a floor which would simulate an infinitely thick earth. An excavation of this magnitude is not only costly, but it is also not feasible in many urban areas.

It is an object of this invention to provide a floor or surface with microwave reflectivity properties similar to those of an infinitely thick earth.

It is another object to provide an earth-simulating floor which can be set up and operated in a limited amount of space.

A further object is to provide an anechoic chamber having a floor with microwave reflectivity properties similar to those of an infinitely thick earth.

## SUMMARY OF THE INVENTION

The present invention involves a composite floor or surface which simulates the earth with respect to microwave reflectivity. The floor is made up of two or more distinct layers of various materials. The first layer, the lowermost layer, is made of a metallic material. This layer is covered with a second layer made of a lossy material.

A third layer, made of a rigid nonmetallic material, may be placed over the layer of lossy material for the purpose of providing a durable base for supporting the electronic equipment to be tested.

Between the layer of metallic material and the layer of rigid nonmetallic material is disposed a system for (a) supporting the layer of nonmetallic material and (b) containing the lossy material. The material making up the support system must be made of a nonmetallic material in order to maintain suitable dielectric properties of the composite floor. The material of the support system and the material of the rigid nonmetallic layer should also be coated with a lossy coating in order to further suppress reflections by making the floor more lossy.

The above-described floor composition simulates an infinitely thick earth with respect to the earth's electromagnetic properties, i.e., reflectivity of microwave energy over a broad range of frequencies.

## BRIEF DESCRIPTION OF THE DRAWINGS

Figure 1 is a perspective view, partially in section, of the composite floor of the present invention.

Figure 2 is a side elevation in section of an anechoic chamber embodying this invention.

Figure 3 is a plan view of a preferred embodiment of this invention.

Figure 4 is an enlarged view of the embodiment shown in Figure 3.

Figure 5 is a cross-sectional view taken along line 5-5 in Figure 4.

## DETAILED DESCRIPTION

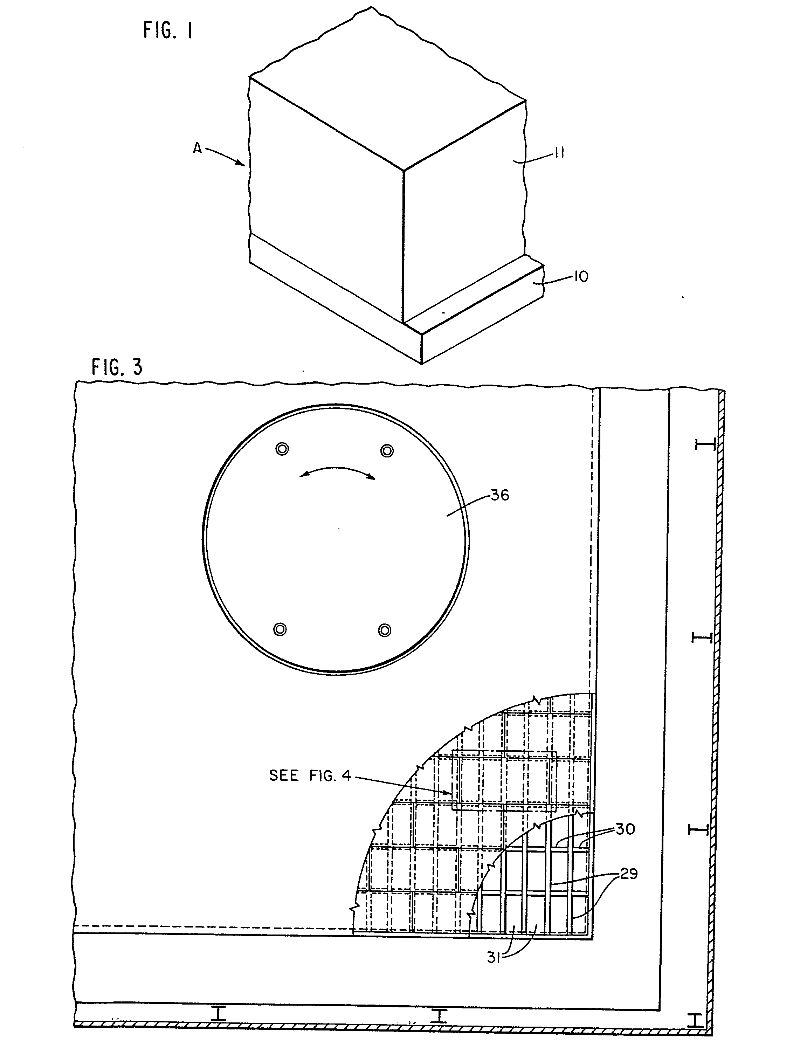

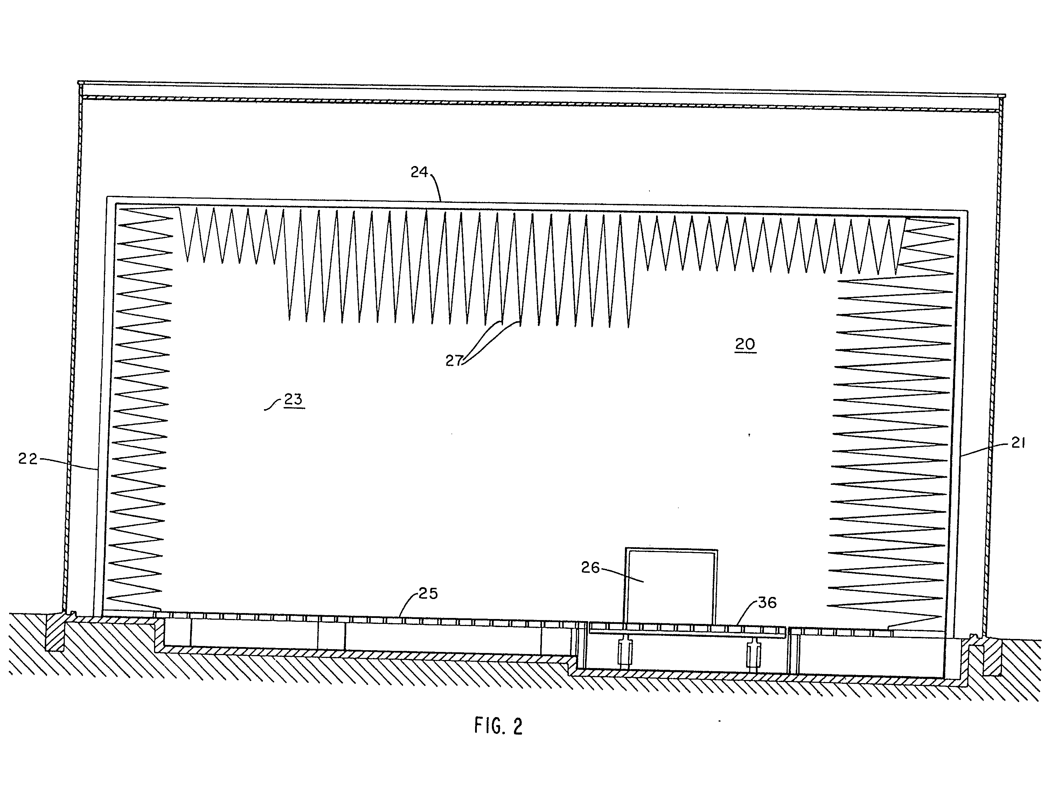

Referring now to Fig. 1, "A" depicts the present invention in its most elementary form. The lowermost layer 10 is made of a metallic material. Suitable materials for the layer include galvanized steel, aluminum, copper, iron, stainless steel, and any metallic screen. Any material which is a good conductor of electricity is suitable as a material for layer 10. The main considerations for a suitable metal are that it be of reasonable cost and high durability.

The metallic layer 10 is critical to the composite floor. The reflectivity of the composite floor is a function of the material which makes up the lowermost layer 10. The metal backing of the composite floor normalizes the performance of the floor and renders it capable of simulating the reflectivity properties of an infinitely thick earth. The term "normalize" refers to the fact that the metal backing allows the reflectivity of lowermost layer to be uniform over its surface. Furthermore, the reflectivity of the metal is known to be 100 percent. Thus, the backing is eliminated as a source of variation in the reflectivity of the floor. The second layer 11, which is located above the lowermost layer, is made of a lossy light weight material.

—5—

The term "lossy" may be defined as that property of a material which exhibits a relatively high degree of loss or dissipation of electromagnetic energy. A lossy material dissipates electromagnetic energy by means of conversion into heat. In other words, the electromagnetic energy has been "lost" because it has been converted into a different form of energy, namely, heat energy. The term "loss factor" is used as a measure of this loss, and is the imaginary part of the expression for the dielectric constant, which is a complex number. In the context of this invention, the term "lossy" may be used to describe a material, or a structural element such as a wall, floor, or ceiling. The structural element can be of single layer or multiple layer construction.

The lossy light weight layer 11 is also critical to the composite floor. The material which makes up this layer need not have tightly controlled dielectric properties.

The following Table lists the dielectric properties of the lossy material which is suitable for use in the composite floor:

TABLE I

| Frequency, GHz | Dielectric Constant | Loss Factor |
| --- | --- | --- |
| 0.03 | 11 - 30 | 0.2 - 4.0 |
| 0.10 | 10 - 30 | 0.2 - 36 |
| 0.30 | 3 - 15 | 0.3 - 60 |
| 1.00 | 3 - 20 | 0.6 - 40 |
| 3.00 | 2 - 14 | 0.7 - 30 |
| 10.00 | 2 - 4 | 0.3 - 10 |

The lossy material also need not have specific structural properties. However, the material should be protected from moisture, because the
presence of moisture can result in a change of dielectric properties.
Waterproof plastic bags may be employed to encase the lossy material to
prevent it from being affected by moisture.

The lossy material should exhibit a high degree of loss, and
it should not be highly reflective. In terms of dielectric properties,
the material should have a high loss factor accompanied by a low dielectric
constant.

One method of preparing the lossy material is to impregnate
a light-weight plastic foam with a semi-conducting carbon latex solution.
The impregnation step is carried out by dipping the foam into the solution.
After the foam is dried, it will exhibit suitable lossy properties.
The properties of such a foam may be adjusted by controlling the amount
of carbon in the impregnating solution and by varying the number of dips
during the impregnating process. Foams prepared by the foregoing process are widely used in the manufacture of absorbers for anechoic microwave chambers. A lossy light weight material suitable for use in the
present invention is known by the trade name ECCOSORB LS. This product
is manufactured by Emerson & Cuming, Inc., Canton, Massachusetts.

An experimental approach to finding the optimum grade of light-
weight lossy foam material for a given application, i.e., simulation
of electromagnetic and microwave reflectivity properties of the earth at a given location on the earth, is required. An attempt to predict performance of the lossy foam material from approximate or assumed dielectric properties is not possible. However, direct experimentation to optimize the parameters of the lossy foam for a specific application, e.g., dielectric properties, layer thickness, is well within the ability of one who is skilled in the art of analyzing the electromagnetic and microwave reflectivity properties of the earth.

The layer of lossy light weight material and the layer of metallic material can be bonded together or unbonded, depending upon the ultimate use of the composite floor. If bonding is desired, the bonding material should be compatible with the materials to be bonded, and should have high bond strength and long life. Suitable bonding materials include Eccobond 87H (NF), a general purpose solvent based adhesive manufactured by Emerson & Cuming, Canton, Massachusetts. The properties of this adhesive are summarized in the following table:

## TABLE II

| | |
|---|---|
| Compatible Solvent | Trichloroethane |
| Peel Strength After 72 Hours | >50 lbs./in. |
| Volume Resistivity | $10^{12}$ ohm-cm |
| Dielectric Strength | 300 volts/mil. |
| Viscosity | 600-1000 cps at 25°C |

The advantages of using the above described composite floor as a means for simulating an infinitely thick earth are uniformity, reliability, and portability. With respect to uniformity and reliability the composite flooring material exhibits an unvarying loss factor throughout its entire area. With respect to portability, the flooring material can be moved to any part of the world and still retain its original properties.

The composite floor described above can simulate an infinitely thick earth with respect to electromagnetic and microwave reflectivity properties. It should be noted that the earth itself does not have constant electromagnetic and microwave reflectivity properties over its entire surface. For example, properties over large bodies of water are significantly different from those properties over large land masses.

The use of the composition floor as the base of an anechoic chamber will be described in the example which follows. However, it should be understood that the composite floor disclosed herein is not limited to use in anechoic chambers. The composite floor may be used by itself or may be incorporated into other structures in addition to anechoic chambers. It should also be understood that modifications to the composite floor can be made without departing from the spirit and scope of the invention.

## EXAMPLE I

At the present time, the composite floor of the present invention finds its major utilization in anechoic chambers.

The simplest configuration of an anechoic chamber is a rectangular room with flat internal surfaces covered with absorbing material. The addition of one or several varieties of baffles or modification of chamber shape may bring about further reduction of chamber reflectivity or equivalent reflectivity at reduced cost. Descriptions of anechoic chambers may be found in Buckley, United States Patent 3,113,271; Buckley, United States Patent 3,120,641; Emerson, United States Patent 3,273,150; Emerson, etal, United States Patent 3,295,133; Emerson, United States Patent 3,308,463.

In the present invention, the composite floor will be part of an anechoic chamber which is in the shape of a rectangular room. However, it should be noted that rooms of other shapes can be used and that the particular shape of the room is not a part of the present invention.

Referring now to Fig. 2, the rectangular shaped anechoic chamber 20 is defined by a front wall 21, back wall 22, side wall 23, ceiling 24, and floor 25. Only one side wall is shown. The walls 21, 22, 23 and ceiling 24 of the chamber 20 are formed by any conventional structural material, the specific structural materials selected for use in the chamber walls 21, 22, 23 and ceiling 24 not being a part of the present invention. The chamber 20 is also provided with a door 26 through which the device to be tested and personnel can enter the chamber.

The basic unit of construction in the anechoic chamber is a sheet of rigid nonmetallic material clad on both sides with metallic material. The preferred nonmetallic material is plywood and the preferred metallic material is heavy gauge galvanized steel. The design is effective over a frequency range of 30 MHz to 1000 MHz. However, this design should be effective over a broader range of frequencies.

Other suitable cladding metals include stainless steel, aluminum, and copper.

The size of the chamber 20 will vary depending upon the types of devices to be evaluated, but it should be large enough to accommodate an automobile, truck or similar vehicle.

The interior surfaces of the front 21, back 22, and side walls 23 and of the ceiling 24 of the chamber 20 are lined with microwave energy absorbing material 27 which is intended to absorb any microwave energy which impinges against it. The particular lining material chosen to line walls 21, 22, 23 and ceiling 24 of the anechoic chamber 20 will vary depending upon the requirements of the chamber. Usually broad band absorbing materials are employed for lining the chamber so that the chamber can be utilized for evaluating devices over a greater frequency range thereby providing the chamber with greater versatility. United States Patents 2,464,006; 2,977,591; 2,822,539; 2,870,439, disclose lining materials which are suitable for anechoic chambers. In the embodiment shown in Fig. 2, the walls 21, 22, 23 and the ceiling 24 are lined with pyramidal microwave absorbers 27. These absorbers 27 are made of light weight polyurethane foam. The pyramids 27 are mounted on a solid flexible base which is also made of light weight polyurethane foam. The absorber 27 is effective with linear, circular, or elliptical polarization. A suitable absorber is known by the trade name Eccorsorb HPY or Eccosorb VHP, both of which are produced by Emerson & Cuming, Canton, Massachusetts.

The floor 25 of the anechoic chamber 20 utilizes, as its basic component, the composite floor "A" of the present invention. The base of floor 25 comprises a structural material clad with a metallic material. The preferred structural material is plywood. Other types of wood are acceptable substitutes for plywood.

The metallic material which covers the upper portion of the plywood structural material forms the lowermost layer 10 of the composite floor "A". The metallic covering 10 has the function of normalizing the performance of the composite floor.

The metallic material which covers the lower portion of the plywood structural material merely acts as a means for shielding the anechoic chamber from extraneous and undesired electromagnetic signals. Suitable materials for the metallic covering include galvanized steel, aluminum, and copper.

Over the lowermost layer 10 is placed a layer 11 of lossy material. This material should be protected from moisture, in order to prevent substantial changes in dielectric properties. The lossy material may be sealed in waterproof plastic bags. A suitable material for this layer of lossy material can be made by impregnating an open-cell polyurethane foam with a neoprene latex loaded with carbon powder. The preferred material is a lightweight flexible foam which is identified by the trade name ECCOSORB LS. This foam is manufactured by Emerson & Cuming, Canton, Massachusetts. The weight of this material is approximately 0.08 g/cc. This material can be readily cut with a die, scissors, etc. It is nonmagnetic and exhibits high dielectric loss. The dielectric properties should correspond to those set forth in Table I. The thickness of the layer of lossy material can be varied to provide the desired loss factor.

Because heavy automotive vehicles must be driven over the floor 25 of the anechoic chamber 20, it is preferable to provide a rigid covering 28 over the lossy layer 11 to prevent the lossy material from shifting under the weight of the vehicles. However, the rigid covering 28 may be omitted without detrimentally affecting the earth-like properties of the floor. The material for the rigid covering 28 should be strong and durable, while at the same time be of reasonable cost. Suitable materials include plywood, and wood of other types of construction. To insure that the rigid covering 28 remains stable, it should be supported with structural components.

The structural system is formed by placing continuous sleepers 29 at predetermined intervals upon the lowermost layer of 10 the chamber floor 25. The sleepers 29 are bonded to the lowermost layer 10 with a suitable adhesive. A suitable adhesive for this application would be epoxy based and would have the following properties:

## TABLE III

| Property | Typical Value |
|---|---|
| Hardness (Shore A) | 70 |
| Bond strength in shear at room temperature | 3100 psi (217 kg/cm$^2$) |
| Bond strength after 30 day soak in water | 2900 psi (203 kg/cm$^2$) |
| Flexural strength | 5500 psi (385 kg/cm$^2$) |

The sleepers 29 are reinforced by placing cross-pieces 30 flush against the sleepers 29 at predetermined intervals. The cross-pieces 30 are bonded to the lowermost layer 10 with a suitable adhesive. The sleepers and cross-pieces should be formed from a rigid nonmetallic material. Wood is the preferred material for forming the sleepers and cross-pieces. In Figure 3, it can be seen that the system formed by the sleepers 29 and cross-pieces 30 comprises a series of rectangular boxes 31. However, it should be noted that it is not necessary that the sleepers 29 and cross-pieces 30 form a series of rectangular boxes 31. Rectangular boxes are preferred because they provide an acceptable degree of stability with a minimum number of design problems.

The following table lists typical dimensions for the sleepers 29 and cross-pieces 30. However, the particular dimensions listed are not critical to the invention and are not meant to be a limitation of the scope of the invention.

TABLE IV

| | Length | Depth or Thickness | Height | Interval Between Like Components |
|---|---|---|---|---|
| Sleeper | Continuous | 60 mm | 130 mm | 610 mm |
| Cross-Pieces | 610 mm | 60 mm | 130 mm | 1,220 mm |

The rectangular boxes 31 thus formed by the sleepers 29 and cross-pieces 30 are filled with small pieces of lossy light weight foam. At least 70% of the space between the lowermost layer 10 and the plywood layer 28 should be filled with the lossy material. If the height of the sleepers 29 and cross-pieces 30 is 130 mm, the depth of the foam layer 19 should be approximately 90 mm to 130 mm. The thickness of the plywood layer 28 should be at least about one inch for structural purposes. The plywood layer 28 is joined to the sleepers 29 by means of nonmetallic studs 32, nuts 33 and washers 34. The studs 32 are countersunk into the plywood layer 28 and project into the sleepers 29. The studs 32 are bonded to the sleepers 29 with a suitable adhesive. The properties of a suitable adhesive are set forth in Table III. The studs 32, nuts 33, and washers 34 are preferably made of a plastic material.

The plywood layer 28 should be covered with a material which will protect the plywood from foreign bodies introduced into the anechoic chamber 20 by operators and by the equipment being tested. A suitable material for covering the plywood layer 28 is a thin layer of lossy vinyl material 35. This layer 35 should be impervious to moisture and resistant to wear from foot traffic and transportation of instruments and appliances. Any high quality floor tile would be satisfactory. Suitable floor tiles include vinyl-asbestos tiles manufactured by Armstrong Cork Co. and vinyl-asbestos tiles manufactured by the GAF Corporation.

The vehicle rests on the floor 25 of the chamber 20 in order to obtain the benefit of the simulation of the earth. The floor 25 of the chamber 20 may include a turntable 35 to permit the object being tested to be rotated. The turntable 35 is constructed in the same manner and of the same material as the floor 25 of the chamber 20.

WHAT I CLAIM IS:

1. A composite structure comprising (a) a first layer made of an electrically conducting material, and (b) a second layer made of a lossy material, said structure capable of simulating an infinitely thick earth with respect to its reflectivity of electromagnetic energy.

2. The structure of Claim 1 wherein the electrically conducting material has total reflectivity and zero transmissivity of electromagnetic energy.

3. The structure of Claim 1 wherein the lossy material has dielectric constant and dielectric loss factor such that the composite structure simulates infinitely thick earth with respect to reflectivity of electromagnetic energy.

4. The structure of Claim 1 wherein the lossy material of the second layer is enclosed in a water impervious material.

5. In an anechoic chamber having a ceiling, side walls, a front wall, a back wall, and a floor, the improvement wherein said floor has electromagnetic reflective properties similar to those of infinitely thick earth.

6. The floor of Claim 5 wherein said floor is comprised of

(a) a lowermost layer formed of an electrically conducting metallic material, and

(b) a second layer disposed upon said lowermost layer, said second layer being made of lossy nonmetallic material.

7. The floor of Claim 6 including a third layer disposed upon said second layer, said third layer being made of rigid nonmetallic material.

8. The floor of Claim 7 including a fourth layer disposed upon said third layer, said fourth layer being made of lossy nonmetallic material.

9. The floor of Claim 6 wherein the lowermost layer is made of a metallic material selected from the group consisting of galvanized steel, stainless steel, aluminum, copper, and iron.

10. The floor of Claim 6 wherein the lossy nonmetallic material is a lossy light-weight foam.

11. The floor of Claim 7 wherein the rigid nonmetallic material forming the third layer is made from wood.

12. The floor of Claim 7 wherein the third layer is supported by a nonmetallic structural system which is mounted upon said lowermost layer.

13. The floor of Claim 12 wherein the structural system is comprised of a plurality of containers formed from a plurality of nonmetallic sleepers placed in parallel arrangement along said lowermost layer, said sleepers being stabilized by a plurality of nonmetallic cross-pieces placed perpendicular to said sleepers and being flush against said sleepers.

14. The floor of Claim 13 wherein the containers formed by the nonmetallic structural system enclose the lossy nonmetallic material of the second layer.

15. The floor of Claim 13 wherein the rigid nonmetallic layer and the material of the sleepers and cross-pieces are coated with lossy coating material.

1|3

FIG. 1

A

11

10

FIG. 3

36

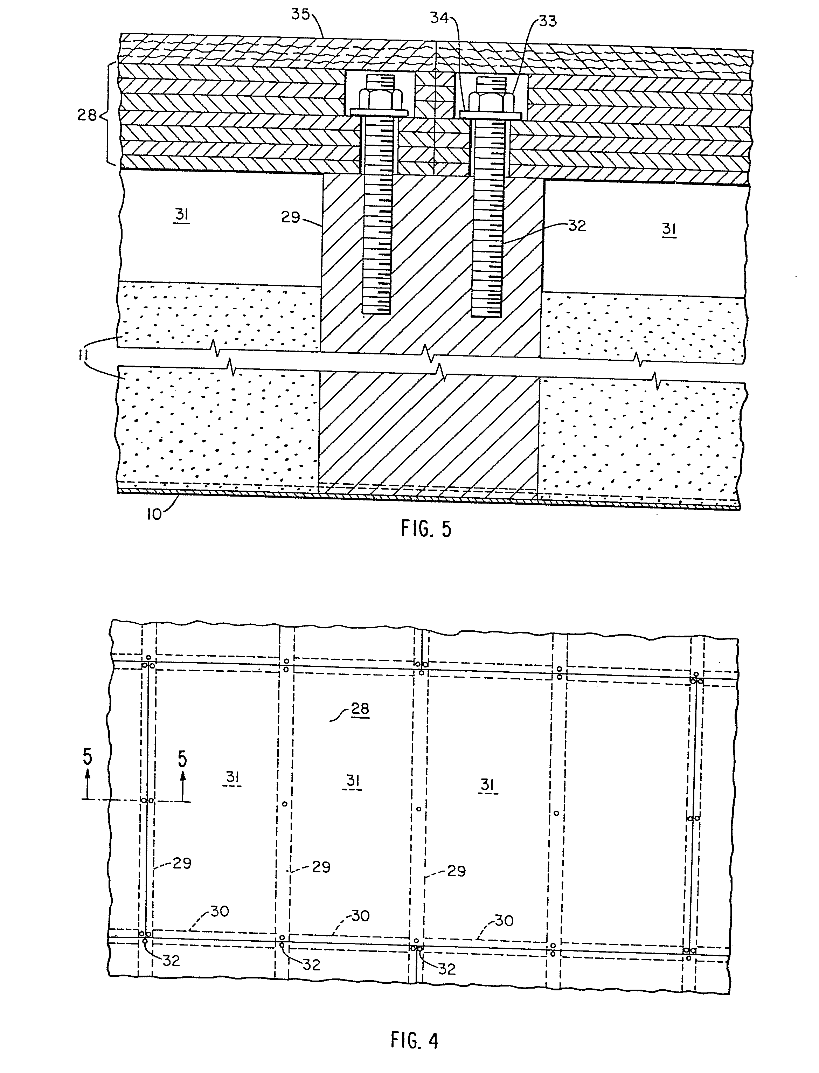

SEE FIG. 4

30

29

31

FIG. 2

FIG. 5

FIG. 4

0054098

European Patent
Office

**EUROPEAN SEARCH REPORT**

Application number

EP 81 10 4395

| | DOCUMENTS CONSIDERED TO BE RELEVANT | | CLASSIFICATION OF THE APPLICATION (Int. Cl. 3) |
|---|---|---|---|
| Category | Citation of document with indication, where appropriate, of relevant passages | Relevant to claim | |
| X/Y | US - A - 3 994 105 (JAMISON et al.) <br><br> * column 1, line 47 to column 4, line 29; figures 1-4 * <br><br> --- | 1,2,4, 5,9, 10,12- 14 | H 05 K 9/00 |
| P | EP - A - 0 027 290 (BAETEN N.V.) <br><br> * page 1, last paragraph to page 3, 2nd paragraph; figure 1 * <br><br> & BE - A - 879 315, 01-02-1980 <br><br> --- | 1,2,10 | |
| Y | US - A - 2 753 390 (FEKETICS) <br><br> * column 2, lines 19 to 70; figure 1 * <br><br> --- | 5-7,9, 11-13 | **TECHNICAL FIELDS SEARCHED (Int.Cl. 3)** <br><br> H 05 K <br> E 04 B <br> G 01 R |
| A | IEEE TRANSACTIONS ON INSTRUMENTA- TION AND MEASUREMENT, volume IM- 26, nr. 3, September 1977 <br> NEW YORK (US) <br> M.L. CRAWFORD et al.: "Generation of EM susceptibility test fields using a large absorber-loaded TEM cell", <br> pages 225-230 <br><br> * the article to page 226, left- hand column, 2nd paragraphe; figures 1-4 * <br><br> --------- | 1,2,5, 6,9 | **CATEGORY OF CITED DOCUMENTS** <br><br> X: particularly relevant if taken alone <br> Y: particularly relevant if combined with another document of the same category <br> A: technological background <br> O: non-written disclosure <br> P: intermediate document <br> T: theory or principle underlying the invention <br> E: earlier patent document, but published on, or after the filing date <br> D: document cited in the application <br> L: document cited for other reasons <br><br> &: member of the same patent family, corresponding document |

| | The present search report has been drawn up for all claims | |
|---|---|---|
| Place of search <br> The Hague | Date of completion of the search <br> 17-02-1982 | Examiner <br> STÜBNER |

EPO Form 1503.1 06.78